(19) Europäisches Patentamt
European Patent Office
Office européen des brevets

(11) **EP 3 242 333 B1**

(12) **EUROPEAN PATENT SPECIFICATION**

(45) Date of publication and mention
of the grant of the patent:
**09.09.2020 Bulletin 2020/37**

(21) Application number: **16168160.6**

(22) Date of filing: **03.05.2016**

(51) Int Cl.:
*H01L 31/0203* (2014.01)   *H01L 31/0352* (2006.01)
*H01L 31/112* (2006.01)   *H01L 29/66* (2006.01)
*H01L 31/0216* (2014.01)   *B82Y 10/00* (2011.01)
*B82Y 15/00* (2011.01)

(54) **AN APPARATUS AND METHOD OF FORMING AN APPARATUS COMPRISING A GRAPHENE FIELD EFFECT TRANSISTOR**

VORRICHTUNG UND VERFAHREN ZUR HERSTELLUNG EINER VORRICHTUNG MIT EINEM GRAPHEN-FELDEFFEKTTRANSISTOR

APPAREIL ET PROCÉDÉ DE FORMATION D'UN APPAREIL COMPRENANT UN TRANSISTOR À EFFET DE CHAMP À BASE DE GRAPHÈNE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**08.11.2017 Bulletin 2017/45**

(73) Proprietor: **Nokia Technologies Oy
02610 Espoo (FI)**

(72) Inventors:
• **Harris, Nadine
Cambridge, Cambridgeshire CB3 0FA (GB)**
• **White, Richard
Huntingdon, Cambridgeshire PE28 9DY (GB)**

(74) Representative: **Swindell & Pearson Limited
48 Friar Gate
Derby DE1 1GY (GB)**

(56) References cited:
**US-A1- 2014 126 037   US-A1- 2014 299 741**

• **GERASIMOS KONSTANTATOS ET AL: "Hybrid graphene-quantum dot phototransistors with ultrahigh gain", NATURE NANOTECHNOLOGY, vol. 7, no. 6, 1 January 2012 (2012-01-01) , pages 363-368, XP055039980, ISSN: 1748-3387, DOI: 10.1038/nnano.2012.60**

EP 3 242 333 B1

## Description

TECHNOLOGICAL FIELD

Examples of the disclosure relate to an apparatus and method of forming an apparatus comprising a graphene field effect transistor. In particular, they relate to an apparatus and method of forming an apparatus comprising a graphene field effect transistor where the graphene field effect transistor comprises quantum dots.

BACKGROUND

Graphene field effect transistors (GFETs) and quantum dot-graphene field effect transistors (QD-GFETs) may be used as photodetectors and transduce incident light into a measurable electrical response. It is useful to increase the efficiency of such devices.

Gerasimos Konstantatos et al: Hybrid graphene-quantum dot phototransistors with ultrahigh gain", Nature Nanotechnology, vol. 7, no.6 (2012-01-01), pages 363-378, XP055039980 discloses hybrid graphene-quantum dot phototransistors that exhibit ultrahigh photodetection gain and high quantum efficiency, enabling high-sensitivity and gate-tunable photodetection.

US2014/299741 discloses an apparatus comprising a graphene film; a first arrangement of quantum dots of a first type located in contact with the graphene film as a first monolayer; a second arrangement of quantum dots of a second type located in contact with the graphene film as a second monolayer; an input voltage source connected to an end of the graphene film; and an output voltage probe connected to the graphene film between the first arrangement of quantum dots and the second arrangement of quantum dots.

BRIEF SUMMARY

According to the invention there is provided an apparatus as defined in claim 1.

The quantum dots may comprise more than two layers and different ligands may be used in different layers.

The thickness of at least one of the layers of quantum dots may be arranged to provide an anti-reflective coating. The layers arranged to provide an anti-reflective coating may also be arranged to transduce incident light into an electrical output.

The total thickness of the layers of quantum dots may be between 10-500nm.

The apparatus may comprise an encapsulating layer overlaying the graphene field effect transistor. The encapsulating layer may comprise an organic material. The encapsulating layer may comprise an adhesive. The apparatus may comprise a transparent layer attached to the adhesive.

According to various, but not necessarily all, examples of the disclosure there may be provided a photodetector comprising at least one apparatus according to any preceding claim.

According to the invention there is also provided a method as defined in claim 9.

The method may comprise depositing further layers of quantum dot solution and exchanging ligands to provide further layers of quantum dots connected to ligands.

Exchanging ligands may comprise exchanging a longer ligand for a shorter ligand. Different ligands may be used in different layers of quantum dots.

The thickness of at least one of the layers of quantum dots is arranged to provide an anti-reflective coating. The layers arranged to provide an anti-reflective coating may also be arranged to transduce incident light into an electrical output.

The total thickness of the layers of quantum dots may be between 10-500nm.

The method may comprise providing an encapsulating layer overlaying the graphene field effect transistor. The encapsulating layer may comprise an organic material. The encapsulating layer may comprise an adhesive. The method may comprise providing a transparent layer attached to the adhesive.

According to various, but not necessarily all, examples of the disclosure there is provided examples as claimed in the appended claims.

BRIEF DESCRIPTION

For a better understanding of various examples that are useful for understanding the detailed description, reference will now be made by way of example only to the accompanying drawings in which:

Fig. 1 illustrates an apparatus;
Fig. 2 illustrates another apparatus according to examples of the disclosure;
Fig. 3 illustrates a method;
Fig. 4 illustrates example layers of quantum dots;
Figs. 5A and 5B illustrate reflectance spectra of layers of quantum dots;
Fig. 6 illustrates an example reflectance spectrum; and
Fig. 7 illustrates an example energy diagram.

DETAILED DESCRIPTION

The Figures illustrate an apparatus 1 comprising: a graphene field effect transistor 3 where the graphene field effect transistor 3 comprises a graphene channel 5 and quantum dots 7 provided overlaying the graphene channel 5, wherein the quantum dots 7 comprise a first layer 9 comprising quantum dots 7 connected to a first ligand 11 and a second layer 13 comprising quantum dots 7 connected to a second ligand 15, and wherein the first ligand 11 is configured to cause the first layer 9 to have a first refractive index and the second ligand 15 is configured to cause the second layer 13 to have a second refractive index wherein the second refractive index is different to the first refractive index.

The apparatus 1 may be used as a photodetector. The layers 9, 13 of quantum dots 7 are arranged to detect incident light and transduce the incident light into an electrical output.

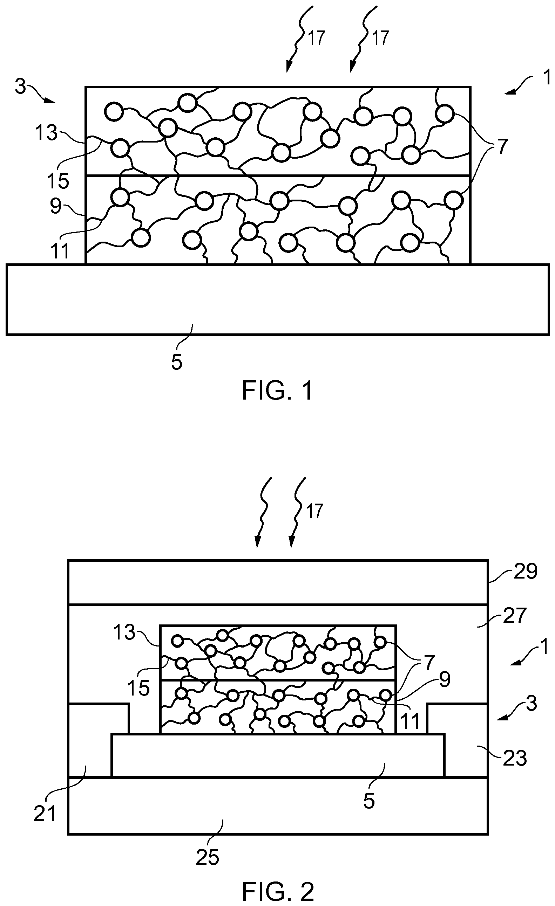

Fig. 1 schematically illustrates an apparatus 1 according to examples of the disclosure. The apparatus 1 comprises a GFET 3 comprising a graphene channel 5 and quantum dots 7 provided overlaying the graphene channel 5.

The graphene channel 5 comprises a thin layer of graphene. In some examples the graphene channel 5 may have a thickness in the range of nanometers. In some examples the graphene channel 5 may comprise an atomic monolayer of graphene.

The quantum dots 7 are coupled to the graphene channel 5. The quantum dots 7 are coupled to the graphene channel 5 so as to enable charge transfer from the quantum dots to the graphene channel 5.

The quantum dots 7 are provided overlaying the graphene channel 5. The quantum dots 7 are provided in a plurality of layers. In the example of Fig. 1 the quantum dots 7 are provided in a first layer 9 and a second layer 13. The second layer 13 is provided overlaying the first layer 9 so that the first layer 9 is positioned between the graphene channel 5 and the second layer 13. In other examples more than two layers of quantum dots 7 may be provided.

The quantum dots 7 may comprise semiconductor nanocrystals in which there is quantum confinement in all three dimensions. The quantum dots 7 may comprise any suitable semiconductor material. The semiconductor material that is used for the quantum dots 7 may be chosen to enable incident light to be detected. In some examples the quantum dots 7 may comprise lead sulphide, cadmium sulphide, cadmium selenide, or any other suitable material.

In some examples the same semiconductor material may be used for the quantum dots 7 in each of the layers 9, 13 within the apparatus 1. In other examples different materials could be used for different layers 9, 13.

The material and/or dimensions of the quantum dots 7 may be selected to optimise the wavelength of light that is detected by the GFET 3. For example where lead sulphide quantum dots 7 are used the quantum dots 7 may have a size of around 3nm. Other dimensions may be used in other examples.

The quantum dots 7 may be any suitable shape. The quantum dots 7 could be spherical, rods, two dimensional shapes or any other suitable shape. Different shapes of quantum dots could be used in the different layers 9, 13

In the example apparatus 1 of Fig. 1 the quantum dots 7 are connected to ligands 11, 15. In the first layer 9 of quantum dots 7 a first ligand 11 is connected to the quantum dots 7 and in the second layer 13 of quantum dots a second ligand 15 is connected to the quantum dots 7. The first ligand 11 and the second ligand 15 are different ligands so that the different layers 9, 13 of quantum dots 7 have different refractive indices. In some examples the different ligands may comprise different materials. In some examples the different ligands may comprise different ligand coverage levels or any other suitable differences.

The ligands 11, 15 may be configured to connect the quantum dots 7 to each other. The ligands 11, 15 may also be configured to connect the quantum dots 7 to the graphene channel 5.

In some examples of the disclosure the layers 9, 13 of quantum dots 7 may comprise more than one ligand. For instance the first layer 9 could comprise a combination of two or more ligands and the second layer 13 could comprise a different combination of ligands.

The ligands 11, 15 may comprise any suitable material. The material or materials that are used for the ligands 11, 15 may be chosen dependent upon the refractive index that is needed, the materials used for the quantum dots 7 or any other suitable factor. In some examples the ligands 11, 15 may comprise alkanedithiol; where the alkane comprises methane, ethane, propane, butane or any other suitable alkane; alkanethiol; amine such as butylamine; pyridine or any other suitable material.

The quantum dots 7 are arranged to sense incident light 17. In some examples the quantum dots 7 may generate excitons in response to incident light 17. The excitons may be separated into electron-hole pairs and either the holes or electrons may be transferred from the quantum dots 7 to the graphene channel 5. This provides a doping effect in the graphene channel 5 so that the output of the apparatus 1 is indicative of the incident light 17.

The thickness of the layers 9, 13 of quantum dots 7 are configured to allow for optimal charge transfer from the quantum dots 7 to the graphene channel 5. In some examples the total thickness of the combined layers of quantum dots 7 may be between 50 and 500nm. The thickness that is used may depend on the materials that are used for the quantum dots 7 and the ligands 11, 15 and/or the wavelength of light that is to be detected and/or any other suitable factor.

The thickness of at least some of the layers of quantum dots 7 may be configured to provide an anti-reflective coating. In the example of Fig. 1 the thickness of the second layer 13 of quantum dots 7 are configured to provide an anti-reflective coating. The thickness that is needed to provide an anti-reflective coating may depend on the refractive indices of the respective layers 9, 13, the wavelength of light 17 that is to be detected and any other suitable factors.

The second layer 13 of quantum dots 7 acts both as an anti-reflective coating to reduce the amount of light 17 reflected by the apparatus 1 and also as a transducer to convert at least some of the incident light into an electrical response. In examples where more than two layers 9, 13 of quantum dots are provided any one or more of the upper layers may act as both an anti-reflective coating and also as a transducer.

Fig. 2 illustrates another apparatus according to examples of the disclosure. The apparatus 1 of Fig. 2 also comprises a GFET 3 comprising a graphene channel 5 and a plurality of layers 9, 13 of quantum dots 7 which may be as described above.

The graphene channel 5 extends between a source electrode 21 and a drain electrode 23. The graphene channel 5 and the source electrode 21 and drain electrode 23 may be provided on a flexible substrate 25. This may enable a flexible apparatus 1 to be provided.

The quantum dots 7 are provided overlaying the graphene channel 5 in a plurality of layers 9, 13 where each layer comprises a different ligand 11, 15 or combination of ligands. The plurality of layers 9, 13 may be as described above. In the example of Fig. 2 the apparatus 1 comprises two layers 9, 13 of quantum dots 7. It is to be appreciated that more than two layers 9, 13 could be provided in other examples of the disclosure.

In the example apparatus 1 of Fig. 2 an encapsulating layer 27 is provided overlaying the GFET 3. The encapsulating layer 27 is provided overlaying both the graphene channel 5 and the quantum dots 7. The encapsulating layer 27 may be configured to act as a barrier to protect the GFET 3 from contaminants such as water, oxygen or other chemicals.

The encapsulating layer 27 may comprise any suitable material. In some examples the encapsulating layer 27 may comprise an organic or hybrid organic-inorganic polymer material such as siloxanes, epoxy, acrylic polymers or any other suitable materials. These may be suitable for use in flexible apparatus 1. Other materials may be used in other examples of the disclosure.

The encapsulating layer 27 may be transparent or at least partially transparent to light 17 of the wavelengths that are to be detected by the GFET 3. The encapsulating layer 27 may have a different refractive index to the layers 9, 13 of quantum dots 7. The reflective indices and the thickness of the layers 9, 13 of quantum dots 7 may be configured to reduce the reflection of light 17.

In some examples the encapsulating layer 27 may be an adhesive. The adhesive may enable additional components to be coupled to the GFET 3. In the example of Fig. 2 a transparent layer 29 is attached to the adhesive 27. The transparent layer 29 may comprise glass or any other suitable material. The transparent layer 29 may act as a barrier layer to protect the GFET 3. In some examples the transparent layer 29 may be configured to direct or focus incident light onto the GFET 3.

In the example apparatus of Fig. 2 the ligands used in the respective layers 9, 13 of quantum dots are selected to reduce the reflection of incident light at the boundary between the encapsulating layer 27 and the layers of quantum dots 7. This may increase the proportion of light that reaches the quantum dots 7 and may provide for a more efficient photodetector apparatus 1.

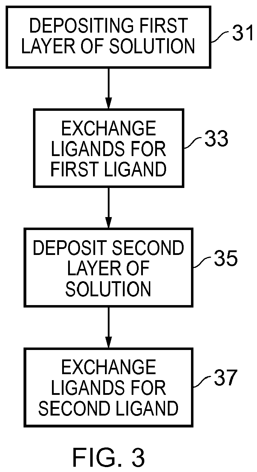

Fig. 3 illustrates an example method. The method may be used to form apparatus 1 such as the apparatus 1 of Figs. 1 and 2.

The method comprises, at block 31, depositing a first layer of quantum dot solution onto a graphene channel 5 of a GFET 3. The graphene channel 5 may be provided on a flexible substrate 25 as described above.

The quantum dot solution may comprise quantum dots 7 connected to a long chain ligand. The long chain ligand may be selected to enable the quantum dots 7 to be dissolved in the solution and prevent the quantum dots 7 from precipitating out of the solution.

The quantum dot solution may be deposited using any suitable deposition process such as ink jet printing or any other suitable technique.

Once the quantum dot solution has been deposited a ligand exchange process is carried out at block 33. The ligand exchange replaces the long chain ligand with the first ligand 11. The first ligand 11 may be a short chain ligand. The first ligand may be a short chain ligand which enables efficient charge transfer from the quantum dots 7 to the graphene channel 5.

Once the ligand exchange process has been carried out the ligand solution may be solidified to form the first layer 9 of quantum dots 7. Any suitable process, such as UV (ultra violet) curing may be used to enable solidification of the quantum dot solution.

Once the first layer 9 of quantum dots 7 has been formed the GEFT 3 may be rinsed to remove the long chain ligand that has been replaced. This may prepare the surface of the GFET 3 for the forming of another layer of quantum dots 7.

At block 35 the method comprises depositing a second layer of quantum dot solution overlaying the first layer 9 of quantum dots 7. The quantum dot solution may be the same as the quantum dot solution used to create the first layer 9 of quantum dots 7 and may comprise the same type of quantum dots 7 connected to the same long chain ligand. In other examples a different solution comprising different quantum dots 7 and/or a different long chain ligand may be used. The quantum dot solution may be deposited using any suitable deposition process such as printing.

Once the quantum dot solution has been deposited a second ligand exchange process is carried out at block 37. The second ligand exchange may replace the long chain ligand of the solution with the second ligand 15. The second ligand 15 may be a short chain ligand which is different to the first ligand 11 used in the first layer 9. The second ligand 15 may be selected to enable efficient charge transfer from the quantum dots 7 to the graphene channel 5. The second ligand 15 may be selected so that the second layer 13 of quantum dots 7 has a different refractive index to the first layer 9 of quantum dots 7.

Once the ligand exchange process has been carried out the ligand solution may be solidified to form the second layer 13 of quantum dots 7. Any suitable process, such as UV (ultra violet) curing may be used to enable solidification of the quantum dot solution.

Once the second layer 13 of quantum dots 7 has been formed the GEFT 3 may be rinsed to remove the long chain ligand that has been replaced by the second ligand exchange process.

Once the second layer 13 of quantum dots 7 has been formed the encapsulating layer 27 may be provided overlaying the second layer 13. A further transparent layer 29 may then be provided over the encapsulating layer.

In the example method of Fig. 3 two different layers 9, 13 of quantum dots 7 are formed. In other examples more than two layers of quantum dots 7 could be formed. The additional layers could be provided by depositing further layers of quantum dot solution overlaying the second layer and performing further ligand exchange processes.

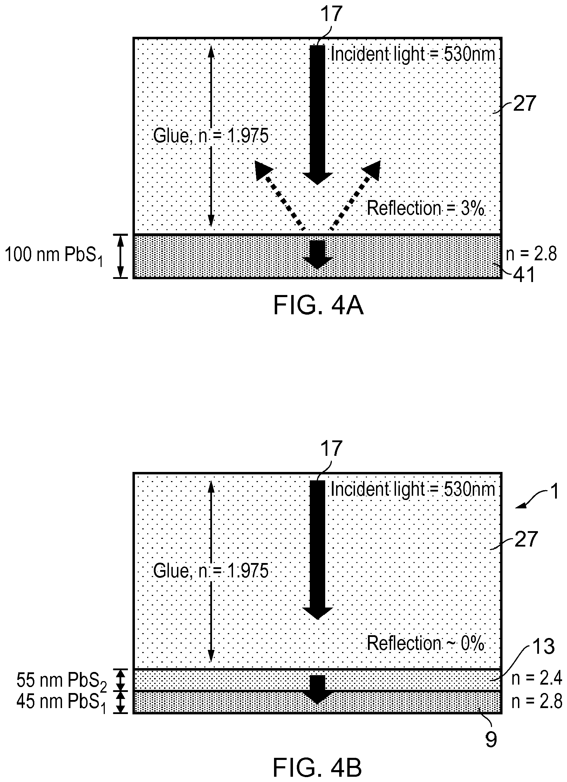

Figs. 4A and 4B illustrates example layers of quantum dots 7 and example refractive indices. The example of Fig. 4A illustrates a single layer 41 of quantum dots 7 and an encapsulating layer 27. Fig. 4B illustrates a plurality of layers 9, 13 of quantum dots 7 and an encapsulating layer 27 according to examples of the disclosure. This shows the difference in the amount of light that is reflected with the two different configurations of quantum dots 7.

In the example of Fig. 4A the quantum dots 7 are provided in a single layer 41. The same ligand or combination of ligands is used throughout the layer 41 of quantum dots 7 so that the single layer 41 has a constant refractive index.

In the example of Fig. 4A the single layer 41 of quantum dots 7 may comprise lead sulphide quantum dots 7 having a diameter of around 3nm. The single layer 41 of quantum dots may be formed using a $NH_4SCN$, mercaptopropionic ligand exchange process. The single layer 41 of quantum dots 7 has a refractive index of 2.8.

In the example of Fig. 4A the single layer 41 of quantum dots 7 has a thickness of 100nm. The thickness of the single layer 41 may be selected to optimize the absorption of incident light and the transfer of charge from the quantum dots 7 to the graphene channel 5 in response to the incident light 17.

An encapsulating layer 27 is provided overlaying the single layer 41 of quantum dots 7. The encapsulating layer 27 may be provided in a much thicker layer than the quantum dots 7. The encapsulating layer 27 may comprise an adhesive or any other suitable material. The encapsulating layer 27 has a different refractive index to the single layer 41 of quantum dots 7. In the example of Fig. 4A the encapsulating layer 27 has a refractive index of 1.975. Other types of encapsulating layer 27 could be used in other arrangements and these may have different refractive indices.

The difference in the refractive indices at the boundary between the encapsulating layer 27 and the single layer 41 of quantum dots 7 causes some of the incident light 17 to be reflected at the boundary. In the example of Fig. 4A the incident light has a wavelength of 530nm and 3% of the incident light is reflected.

In the example of Fig. 4B the quantum dots 7 also comprise lead sulphide. The quantum dots 7 are provided in a first layer 9 and a second layer 13. The second layer 13 is provided overlaying the first layer 9. Different ligands 11, 15 are used in the different layers 9, 13 so that the first layer 9 has a different refractive index to the second layer 13.

The first layer 9 of quantum dots 7 comprises lead sulphide quantum dots 7 having a diameter of around 3nm. The first layer 9 of quantum dots 7 may be formed using a $NH_4SCN$, mercaptopropionic ligand exchange process. The second layer 13 of quantum dots 7 also comprise lead sulphide quantum dots 7 having a diameter of around 3nm. The second layer 13 of quantum dots 7 may be formed using a 1,3 BDT, benzenedithiol ligand exchange process. In the example of Fig. 4B the first layer 9 has a refractive index of 2.8 and the second layer 13 has a refractive index of 2.4.

The different layers 9, 13 of quantum dots 7 also have different thicknesses. In the example of Fig. 4B the first layer 9 has a thickness of 45nm and the second layer 13 has a thickness of 55nm. This may provide a total thickness for combined layers 9, 13 of quantum dots of 100nm. This total thickness may be selected to optimize the absorption of incident light and the transfer of charge from the quantum dots to the graphene channel 5 in response to the incident light. The different thickness of the different layers 9, 13 may be selected to optimize the amount of light that is reflected by the apparatus 1.

The example apparatus 1 of Fig. 4B also comprises an encapsulating layer 27 overlaying the layers 9, 13 of quantum dots 7. The encapsulating layer 27 may be the same as the encapsulating layer 27 of Fig. 4A and may have a refractive index of 1.975. Other types of encapsulating layer 27 may be used in other examples of the disclosure.

The difference in the refractive indices at the boundary between the encapsulating layer 27 and the second layer 13 of quantum dots 7 is reduced compared to the example of Fig. 4A. This reduces the amount of incident light 17 that is reflected at the boundary.

The thickness of the second layer 13 of quantum dots 7 are selected to reduce the amount of incident light 17 that is reflected. The thickness of the second layer 13 of quantum dots 7 may be selected so that for light of a particular wavelength none of the incident light 17 is reflected. The thickness of the second layer 13 of quantum dots may be configured to create destructive interference for light path interactions at the boundary between the second layer 13 of quantum dots 7 and the encapsulating layer 27.

In order to create the destructive interference the thickness of the second layer 13 of quantum dots 7 may be proportional to the wavelength of the incident light 17 and the refractive index of the second layer 13. The thickness t of the second layer 13 may be given by:

$$t = \frac{\lambda}{4n_2}$$

Where A is the wavelength of the incident light and $n_2$ is the refractive index of the second layer 13 of quantum dots 7.

The ligand 15 that is used for the second layer 13 of quantum dots 7 may be selected to provide a desired refractive index. The refractive index that is needed is given by:

$$n_2 = \sqrt{n_1 n_e}$$

Where $n_1$ is the refractive index of the first layer 9 of quantum dots 7 and the $n_e$ is the refractive index of the encapsulating layer 27.

In the example of Fig.4B the destructive interference is achieved by having the thickness of the second layer 13 of quantum dots 7 as 55nm and refractive index of 2.4. As the optimal overall thickness of the combined layers 9, 13 of quantum dots is around 100nm this requires a thickness for the first layer 9 of quantum dots 7 of 45nm. In the example of Fig. 4B this reduces the amount of incident light 17 that is reflected to zero and provides a more efficient apparatus 1 compared to the example of Fig. 4A. It is to be appreciated that other thickness of the layers 9, 13 and refractive indices may be used in other examples of the disclosure.

Once the desired refractive index of the layers 9, 13 has been determined the materials that are used for the ligands 11, 15 may be selected to obtain the desired refractive indices.

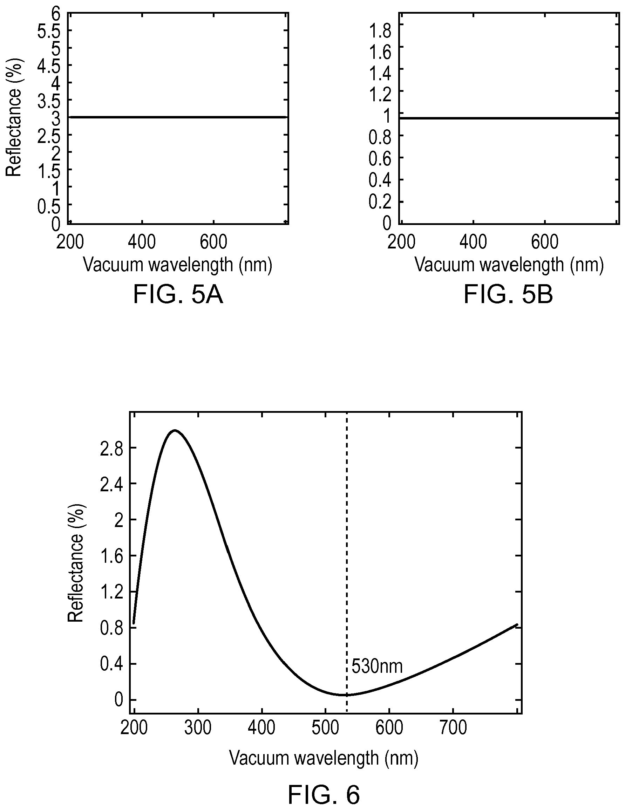

Figs. 5A and 5B illustrate reflectance spectra of layers 9, 13 of quantum dots 7. The reflectance spectra were obtained using finite element simulations to calculate the percentage of reflectance R% of a single layer of quantum dots 7. The layer of quantum dots 7 was a 100nm thick layer of lead sulphide quantum dots 7 for both the spectra of Fig. 5A and Fig. 5B. In the reflectance spectrum of Fig. 5A a refractive index of 2.8 was used and in the reflectance spectrum of Fig. 5B a refractive index of 2.4 was used. The different values of the refractive indices were selected using the equations described above.

The reflectance spectrum of Fig. 5A shows a percentage of reflectance R% of approximately 3% for a refractive index of 2.8. The reflectance spectrum of Fig. 5B shows a percentage of reflectance R% of approximately 1% for a refractive index of 2.4. This shows that the difference between the refractive indices of the encapsulation layer 27 and the quantum dots 7 may be decreased by using different types of ligands for the quantum dots 7. This may enable the second layer 13 of quantum dots 7 to be configured as an antireflective coating.

Fig. 6 illustrates an example reflectance spectrum for an apparatus such as the apparatus of Figs. 1, 2 and 4B. The reflectance spectrum of Fig. 6 was obtained for an apparatus having a first layer 9 of quantum dots 7 of thickness 45nm with refractive index 2.8, a second layer 13 of quantum dots 7 of thickness 55nm with refractive index 2.4 and an encapsulating layer 27 with a refractive index of 1.975. This configuration has reduced the percentage of reflectance R% to approximately 0 for a wavelength of 530nm.

The reflectance spectrum of Fig. 6 shows that the percentage of reflectance R% may be optimized for a wavelength of 530nm so that all of this light reaches the quantum dots 7. This may increase the efficiency of the apparatus 1. It is to be appreciated that the apparatus 1 could be tuned to optimize the percentage of reflectance R% for different wavelengths in other examples of the disclosure.

The reflectance spectrum of Fig. 6 also shows that the percentage of reflectance R% may be increased for other wavelengths of light. This may enable incident light 17 of wavelengths that are not of interest to be reflected. In the example of Fig. 6 the percentage of reflectance R% is increased in the UV spectrum. This may be beneficial as UV light may be used to cure the layers 9, 13 of quantum dots 7. Having the layers of quantum dots 7 configured to reflect the UV light may protect the underlying layers from damage from the UV light during the curing process.

In the examples described above the encapsulation layer 27 has been an adhesive with a refractive index of 1.975. Other types of encapsulation layer 27 may be used in other examples. This may require different refractive indices and/or thicknesses for the layers 9, 13 of quantum dots. For instance, in some examples aluminium oxide could be used as the encapsulation layer 27. This has a refractive index of approximately 1.77 for light with a wavelength of 530nm. In such examples the second layer 13 of quantum dots 7 may be arranged to have a refractive index of 2.23. The different refractive index may be obtained using a different type of ligand or a different combination of ligands and/or different levels of ligand coverage.

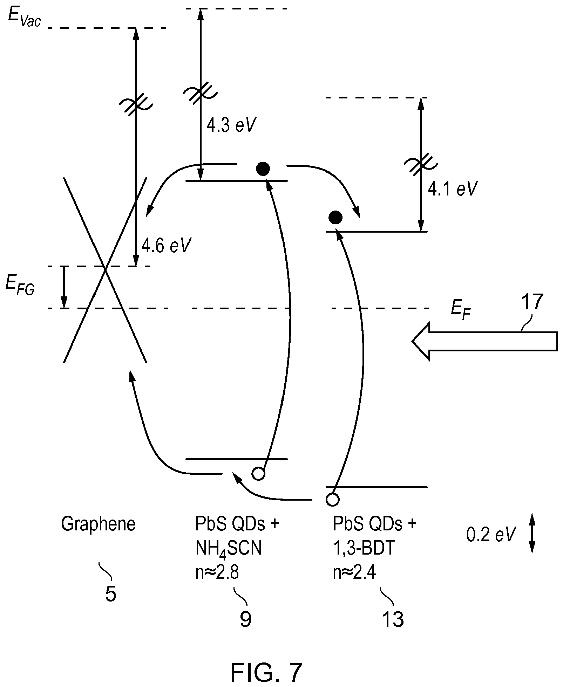

Fig. 7 illustrates an example energy diagram which shows trap mediated charge transfer of holes and electrons between a graphene channel 5 and different layers 9, 13 of quantum dots 7.

As the ligands 11, 15 enable charge transfer from the quantum dots 7 to the graphene channel 5 the use of different ligands will affect the efficiency at which charge is transferred as well as the percentage of incident light 17 that is reflected.

Charges may be transferred from the quantum dots 7 to the graphene channel 5 by two different mechanisms. The first mechanism is band mediated and requires alignment of the energy bands within the different layers 9, 13 of the quantum dots 7.

The second mechanism is trap mediated. This requires hopping and tunneling of charges between the trap sites. This is illustrated in Fig. 7.

Fig. 7 shows the energy levels for the graphene channel, the first layer 9 of quantum dots 7 and the second layer 13 of quantum dots 7. In the example of Fig. 7 the first layer 9 comprises lead sulphide quantum dots 7 and an $NH_4SCN$ terminated ligand and the second layer 13 comprises lead sulphide quantum dots 7 and a BDT terminated ligand.

The incident light 17 generates electron-hole pairs in both the first layer 9 of quantum dots 7 and the second layer 13 of quantum dots 7.

The energetically favorable holes pass from the second layer 13 of quantum dots 7 to the first layer 9 of quantum dots 7. The electrons move in the opposite direction so that the electrons pass from the first layer 9 to the second layer 13. The holes will then pass from the first layer 9 of quantum dots 7 to the graphene channel 5. Fig. 7 shows that there is a small barrier for hole transport from the first layer 9 of quantum dots 7 to the graphene channel 5. This ensures that charges can be transferred from the quantum dots 7 to the graphene channel 5 even when the quantum dots 7 are provided in a plurality of layers.

Examples of the disclosure provide an apparatus 1 that may be used as a photodetector. By providing the quantum dots 7 in a plurality of layers 9, 13 one or more of the layers can act as an antireflective coating which reduces the percentage of incident light 17 reflected by the apparatus 1. This provides for a more efficient photodetector.

In examples of the disclosure, one or more of the layers of quantum dots acts both as an anti reflective coating and as a transducer. This provides an improved photodetector as there is no need to provide additional layers of antireflective coating. This may enable the overall thickness of the apparatus 1 to be minimized as there is no need to introduce the additional anti-reflective layers. Also as there is no need for the additional anti-reflective layers this may make the apparatus 1 easier to fabricate as there is no need to add additional anti-reflective layers.

Examples of the disclosure may enable the reflectance of the light to be optimized for a particular wavelength by selecting appropriate refractive indices and thickness of the layers 9, 13 of quantum dots 7. This may enable the apparatus 1 to be optimized for detecting a particular wavelength or range of wavelengths of light.

In the examples of the disclosure the total thickness of the combined layers 9, 13 of quantum dots maybe kept at an optimum level for absorption of incident light because the anti-reflective properties can be provided by varying the thickness of layers of the quantum dots 7.

The term "comprise" is used in this document with an inclusive not an exclusive meaning. That is any reference to X comprising Y indicates that X may comprise only one Y or may comprise more than one Y. If it is intended to use "comprise" with an exclusive meaning then it will be made clear in the context by referring to "comprising only one..." or by using "consisting".

In this brief description, reference has been made to various examples. The description of features or functions in relation to an example indicates that those features or functions are present in that example. The use of the term "example" or "for example" or "may" in the text denotes, whether explicitly stated or not, that such features or functions are present in at least the described example, whether described as an example or not, and that they can be, but are not necessarily, present in some of or all other examples. Thus "example", "for example" or "may" refers to a particular instance in a class of examples. A property of the instance can be a property of only that instance or a property of the class or a property of a subclass of the class that includes some but not all of the instances in the class. It is therefore implicitly disclosed that a feature described with reference to one example but not with reference to another example, can where possible be used in that other example but does not necessarily have to be used in that other example.

## Claims

1. An apparatus (1) comprising:

   a graphene field effect transistor (3) where the graphene field effect transistor (3) comprises a graphene channel (5) and quantum dots (7) provided overlaying the graphene channel (5), wherein
   the quantum dots (7) comprise a first layer (9) comprising quantum dots (7) connected to a first ligand (11) and a second layer (13) comprising quantum dots (7) connected to a second ligand (15), and wherein
   the first ligand (11) is configured to cause the first layer (9) to have a first refractive index and the second ligand (15) is configured to cause the second layer (13) to have a second refractive index wherein the second refractive index is different to the first refractive index, wherein the thickness of at least one of the layers (9, 13) of quantum dots (7) is arranged to provide an anti-reflective coating, wherein the layers (9, 13) arranged to provide an anti-reflective coating are also arranged to transduce incident light into an electrical output.

2. An apparatus (1) as claimed in any preceding claim wherein the quantum dots (7) comprise more than two layers and different ligands are used in different layers.

3. An apparatus (1) as claimed in any preceding claim wherein the total thickness of the layers (9, 13) of quantum dots (7) is between 10-500nm.

4. An apparatus (1) as claimed in any preceding claim comprising an encapsulating layer (27) overlaying the graphene field effect transistor (3).

5. An apparatus (1) as claimed in claim 4 wherein the encapsulating layer (27) comprises an organic material.

6. An apparatus (1) as claimed in any of claims 4 to 5 wherein the encapsulating layer (27) comprises an adhesive.

7. An apparatus as claimed in claim 6 comprising a transparent layer (29) attached to the adhesive.

8. A photodetector comprising at least one apparatus (1) according to any preceding claim.

9. A method comprising:

depositing a first layer of quantum dot solution onto a graphene channel (5) of a graphene field effect transistor (3);
exchanging ligands to form a first layer (9) of quantum dots (7) connected to a first ligand (11);
depositing a second layer of quantum dot solution overlaying the first layer (9) of quantum dots (7); and
exchanging ligands to form a second layer (13) of quantum dots (7) connected to a second ligand (15), wherein the first ligand (11) is configured to cause the first layer (9) to have a first refractive index and the second ligand (15) is configured to cause the second layer (13) to have a second refractive index wherein the second refractive index is different to the first refractive index, wherein the thickness of at least one of the layers (9, 13) of quantum dots (7) is arranged to provide an anti-reflective coating, wherein the layers (9, 13) arranged to provide an anti-reflective coating are also arranged to transduce incident light into an electrical output.

10. A method as claimed in claim 9 comprising depositing further layers of quantum dot solution and exchanging ligands to provide further layers of quantum dots (7) connected to ligands.

11. A method as claimed in any of claims 9 to 10 wherein exchanging ligands comprises exchanging a longer ligand for a shorter ligand.

12. A method as claimed in any of claims 9 to 11 wherein different ligands are used in different layers of quantum dots (7).

**Patentansprüche**

1. Vorrichtung (1), umfassend:

einen Graphen-Feldeffekttransistor (3) wobei der Graphen-Feldeffekttransistor (3) einen Graphenkanal (5) und Quantenpunkte (7) umfasst, die so vorgesehen sind, dass sie den Graphenkanal (5) überlagern, wobei
die Quantenpunkte (7) eine erste Schicht (9), die Quantenpunkte (7) umfasst, die mit einem ersten Liganden (11) verbunden sind, und eine zweite Schicht (13) umfassen, die Quantenpunkte (7) umfasst, die mit einem zweiten Liganden (15) verbunden sind, und wobei
der erste Ligand (11) so konfiguriert ist, dass er bewirkt, dass die erste Schicht (9) einen ersten Brechungsindex aufweist, und der zweite Ligand (15) so konfiguriert ist, dass er bewirkt, dass die zweite Schicht (13) einen zweiten Brechungsindex aufweist, wobei der zweite Brechungsindex vom ersten Brechungsindex verschieden ist, wobei die Dicke mindestens einer der Schichten (9, 13) von Quantenpunkten (7) so ausgelegt ist, dass sie eine Antireflexbeschichtung bereitstellt, wobei die Schichten (9, 13), die zum Bereitstellen einer Antireflexbeschichtung ausgelegt sind, so ausgelegt sind, dass sie einfallendes Licht in eine elektrische Ausgabe umwandeln.

2. Vorrichtung (1) nach einem der vorhergehenden Ansprüche, wobei die Quantenpunkte (7) mehr als zwei Schichten umfassen, und verschiedene Liganden in verschiedenen Schichten verwendet werden.

3. Vorrichtung (1) nach einem der vorhergehenden Ansprüche, wobei die Gesamtdicke der Schichten (9, 13) von Quantenpunkten (7) 10 bis 500 nm beträgt.

4. Vorrichtung (1) nach einem der vorhergehenden Ansprüche, umfassend eine Verkapselungsschicht (27), die den Graphen-Feldeffekttransistor (3) überlagert.

5. Vorrichtung (1) nach Anspruch 4, wobei die Verkapselungsschicht (27) ein organisches Material umfasst.

6. Vorrichtung (1) nach einem der Ansprüche 4 bis 5, wobei die Verkapselungsschicht (27) ein Haftmittel umfasst.

**7.** Vorrichtung (1) nach Anspruch 6, umfassend eine transparente Schicht (29), die am Haftmittel befestigt ist

**8.** Fotodetektor, umfassend mindestens eine Vorrichtung (1) nach einem der vorhergehenden Ansprüche.

**9.** Verfahren, umfassend:

Abscheiden einer ersten Quantenpunktlösungsschicht auf einen Graphenkanal (5) eines Graphen-Feldeffekttransistors (3);
Austauschen von Liganden, um eine erste Schicht (9) von Quantenpunkten (7) zu bilden, die mit einem ersten Liganden (11) verbunden sind;
Abscheiden einer zweiten Quantenpunktlösungsschicht, welche die erste Schicht (9) von Quantenpunkten (7) überlagert; und
Austauschen von Liganden, um eine zweite Schicht (13) von Quantenpunkten (7) zu bilden, die mit einem zweiten Liganden (15) verbunden sind, wobei der erste Ligand (11) so konfiguriert ist, dass er bewirkt, dass die erste Schicht (9) einen ersten Brechungsindex aufweist, und der zweite Ligand (15) so konfiguriert ist, dass er bewirkt, dass die zweite Schicht (13) einen zweiten Brechungsindex aufweist, wobei der zweite Brechungsindex vom ersten Brechungsindex verschieden ist, wobei die Dicke mindestens einer der Schichten (9, 13) von Quantenpunkten (7) so ausgelegt ist, dass sie eine Antireflexbeschichtung bereitstellt, wobei die Schichten (9, 13), die zum Bereitstellen einer Antireflexbeschichtung ausgelegt sind, so ausgelegt sind, dass sie einfallendes Licht in eine elektrische Ausgabe umwandeln.

**10.** Verfahren nach Anspruch 9, umfassend ein Abscheiden weiterer Quantenpunktlösungsschichten und Austauschen von Liganden, um weitere Schichten von Quantenpunkten (7) bereitzustellen, die mit Liganden verbunden sind.

**11.** Verfahren nach einem der Ansprüche 9 bis 10, wobei das Austauschen von Liganden ein Austauschen eines längeren Liganden gegen einen kürzeren Liganden umfasst.

**12.** Verfahren nach einem der Ansprüche 9 bis 11, wobei verschiedene Liganden in verschiedenen Schichten von Quantenpunkten (7) verwendet werden.

**Revendications**

**1.** Appareil (1) comprenant :

un transistor à effet de champ au graphène (3), le transistor à effet de champ au graphène (3) comprenant un canal de graphène (5) et des boîtes quantiques (7) disposées au-dessus du canal de graphène (5), dans lequel
les boîtes quantiques (7) comprennent une première couche (9) comprenant des boîtes quantiques (7) reliées à un premier ligand (11) et une deuxième couche (13) comprenant des boîtes quantiques (7) reliées à un deuxième ligand (15), et dans lequel
le premier ligand (11) est configuré pour conduire la première couche (9) à avoir un premier indice de réfraction et le deuxième ligand (15) est configuré pour conduire la deuxième couche (13) à avoir un deuxième indice de réfraction, le deuxième indice de réfraction étant différent du premier indice de réfraction, l'épaisseur d'au moins une des couches (9, 13) de boîtes quantiques (7) étant agencée pour fournir un revêtement antireflet, les couches (9, 13) agencées pour fournir un revêtement antireflet étant également agencées pour convertir la lumière incidente en sortie électrique.

**2.** Appareil (1) selon une quelconque revendication précédente dans lequel les boîtes quantiques (7) comprennent plus de deux couches et différents ligands sont utilisés dans différentes couches.

**3.** Appareil (1) selon une quelconque revendication précédente dans lequel l'épaisseur totale des couches (9, 13) de boîtes quantiques (7) se situe entre 10 et 500 nm.

**4.** Appareil (1) selon une quelconque revendication précédente comprenant une couche d'encapsulation (27) recouvrant le transistor à effet de champ au graphène (3).

**5.** Appareil (1) selon la revendication 4 dans lequel la couche d'encapsulation (27) comprend un matériau organique.

**6.** Appareil (1) selon l'une quelconque des revendications 4 et 5 dans lequel la couche d'encapsulation (27) comprend un adhésif.

**7.** Appareil (1) selon la revendication 6 comprenant une couche transparente (29) attachée à l'adhésif.

**8.** Photodétecteur comprenant au moins un appareil (1) selon une quelconque revendication précédente.

**9.** Procédé comprenant :

le dépôt d'une première couche de solution de boîtes quantiques sur un canal de graphène (5) d'un transistor à effet de champ au graphène (3) ;

l'échange de ligands pour former une première couche (9) de boîtes quantiques (7) reliées à un premier ligand (11) ;

le dépôt d'une deuxième couche de solution de boîtes quantiques au-dessus de la première couche (9) de boîtes quantiques (7) ; et

l'échange de ligands pour former une deuxième couche (13) de boîtes quantiques (7) reliées à un deuxième ligand (15), le premier ligand (11) étant configuré pour conduire la première couche (9) avoir un premier indice de réfraction et le deuxième ligand (15) étant configuré pour conduire la deuxième couche (13) à avoir un deuxième indice de réfraction, le deuxième indice de réfraction étant différent du premier indice de réfraction, l'épaisseur d'au moins une des couches (9, 13) de boîtes quantiques (7) étant agencée pour fournir un revêtement antireflet, les couches (9, 13) agencées pour fournir un revêtement antireflet étant également agencées pour convertir la lumière incidente en sortie électrique.

10. Procédé selon la revendication 9 comprenant le dépôt de couches supplémentaires de solution de boîtes quantiques et l'échange de ligands pour obtenir des couches supplémentaires de boîtes quantiques (7) reliées à des ligands.

11. Procédé selon l'une quelconque des revendications 9 et 10 dans lequel l'échange de ligands comprend l'échange d'un ligand plus long contre un ligand plus court.

12. Procédé selon l'une quelconque des revendications 9 à 11 dans lequel différents ligands sont utilisés dans différentes couches de boîtes quantiques (7).

FIG. 1

FIG. 2

FIG. 3

17

Incident light = 530nm

27

Glue, n = 1.975

Reflection = 3%

100 nm PbS₁

n = 2.8

41

## FIG. 4A

17

Incident light = 530nm

1

27

Glue, n = 1.975

Reflection ~ 0%

13

55 nm PbS₂

n = 2.4

45 nm PbS₁

n = 2.8

9

## FIG. 4B

FIG. 5A

FIG. 5B

FIG. 6

$E_{Vac}$

4.3 eV

4.1 eV

4.6 eV

$E_{FG}$

$E_F$

17

Graphene

PbS QDs +
NH$_4$SCN
n≈2.8

PbS QDs +
1,3-BDT
n≈2.4

0.2 eV

5

9

13

FIG. 7

## REFERENCES CITED IN THE DESCRIPTION

**Patent documents cited in the description**

- US 2014299741 A

**Non-patent literature cited in the description**

- **GERASIMOS KONSTANTATOS et al.** Hybrid graphene-quantum dot phototransistors with ultra-high gain. *Nature Nanotechnology,* 01 January 2012, vol. 7, 363-378